# EUROPEAN PATENT APPLICATION

(11) **EP 1 120 475 A1**
(43) Date of publication of application: **01.08.2001**
(21) Application number: 01300635.8
(22) Date of filing: 24.01.2001
(51) Int. Cl.: C23C 16/40, C30B 25/02

(54) **A method and system for MOCVD of PGO films**

(30) Priority: 24.01.2000 US 489857
(71) Applicant: SHARP KABUSHIKI KAISHA, Osaka 545-8522 (JP)
(72) Inventor: Li, Tingkai, Vancouver, WA 98683 (US); Zhang, Fengyan, Vancouver, WA 98683 (US); Hsu, Sheng Teng, Camas, WA 98607 (US)
(74) Representative: Brown, Kenneth Richard

(57) **Abstract**

A method of making ferroelectric PGO thin films includes depositing Pb and Ge on a substrate using a thermal MOCVD process, wherein the Pb and Ge precursor gases are separately supplied to a region adjacent the substrate; annealing the substrate in a first annealing step; forming top electrodes on the substrate; and annealing the substrate in a second annealing step. A system for forming ferroelectric PGO thin films includes a reaction chamber, having a substrate support therein; a substrate located on said substrate support; precursor gas lines extending from a precursor gas source into said reaction chamber; background gas lines for providing a background gas into said reaction chamber; and separation means for separating the precursor gases until the precursor gases are adjacent said substrate.

## Description

### Field of the Invention

The present invention relates to metalorganic chemical vapor deposition (MOCVD) and annealing processes for depositing lead germanium oxide (PGO) thin film materials, and oxide thin films, particularly Pb- and Bi-based oxide thin films, the precursors of which react with oxygen when in a gas phase.

### Background of the Invention

Ferroelectric films have attracted great interest in recent years because of their applications in electro-optic, pyroelectric, frequency agile electronic and non-volatile memory devices. The fabrication and characterization of ferroelectric lead germanium oxide thin films (PGO), such as Pb₅Ge₃O₁₁ and Pb₃GeO₅, are of current interest. Lead germanite (Pb₅Ge₃O₁₁) is a relative new member of ferroelectric family. The ferroelectricity in this material was first discovered by Iwasaki *et al*., Applied Physics Letters, 18, 444 (1971), 43, 4907 (1972). Other work with this material is described in *Ferroelectric memory cell for VLSI ram array and method of making the same,* U.S. Patent Application Serial No. 08/870,375, of Hsu *et al*., filed June 6, 1997. The piezoelectric, dielectric and electric-optic properties of single crystal and polycrystalline materials have been reported in the literature. Pb₅Ge₃O₁₁ is an optically active and ferroelectric material, has a moderate dielectric constant and a small remanent polarization, which make it particularly suitable for ferroelectric non-volatile memory devices such as metal ferroelectric metal oxide silicon (MFMOS), metal ferroelectric metal silicon (MFMS), metal ferroelectric insulators silicon (MFIS), metal-insulator-ferroelectric-silicon (MIFS), metal-insulator ferroelectric insulators silicon (MIFIS), and metal-ferroelectric-silicon (MFS) type memories, Krupanidhi *et al*., Proceedings of the 3d International Symposium on Integrated Ferroelectrics, 100 (1991). Pb₅Ge₃O₁₁ also has potential in thermal detector applications because of its pyroelectric and dielectric characteristics. Pb₃GeO₅ is a ferroelastic material, which may be used for microelectromechanical systems (MEMS) applications.

Thin films of lead germanite have been made by thermal evaporation and flash evaporation, A. Mansingh *et al*., J. Appl. Phys. 51, 5408 (1980); DC reactive sputtering, H. Schmitt *et al*., Ferroelectrics, 56, 141(1984), laser ablation, S.B. Krupanidhi *et al*., Proceedings of the 3d International Symposium on Integrated Ferroelectrics, 100 (1991); and C.J. Peng *et al*., Appl. Phys. Lett. 60, 827 (1992), Sol-gel technique J.J. Lee *et al.,* Appl. Phys. Lett. 60, 827 (1992), and CVD, as described in *Chemical vapor deposition of Pb*_{*5*}*Ge*_{*3*}*O*_{*11*} *thin film for ferroelectric applications,* Chien-Hsiung Peng and J.J. Lee, Serial No. 09/291,688, filed April 13, 1999. Y. Nakao *et al*. *Study on Ferroelectric Thin films for Application to NDRO Nonvolatile Memories* Integrated Ferroelectrics, Vol. 6, 23 (1995). U.S. Patent No. 5,204,314, to Kirlin *et al.,* for *Method for delivering an involatile reagent in vapor form to a CVD reactor,* granted April 20, 1993.

Chemical vapor deposition (CVD) is a particularly attractive method for semiconductor industries because it is readily scaled up to production runs and provides very good step coverage. The electronics industry has extensive experience and tested equipment for CVD technology. This legacy experience and equipment is readily applied to a new CVD processes. In general, the control of key variables such as stoichiometry and film thickness, and the coating of a wide variety of substrate geometries are possible with CVD. Forming thin films by CVD permits the integration of these materials into existing device production technologies. CVD also permits the formation of layers of refractory materials that are epitaxially related to substrates having close crystal structures.

CVD requires that the element source reagents must be sufficiently volatile to permit gas phase transport into the deposition reactor. The element source reagent must decompose in the reactor to deposit only the desired element at the desired growth temperature. Premature gas phase reaction, leading to particulate formation, must not occur, nor should the source reagent decompose in the reactant lines before reaching the reactor deposition chamber. Obtaining optimal conditions to deposit a specific compound requires precise control of stoichiometry that can be achieved only if the reagent is delivered into the reactor in a desired condition.

For PGO (Pb₅Ge₃O₁₁ and Pb₃GeO₅) films, the content of lead to germanium is very high, *i*.*e*., 5:3 and 3:1, respectively. Because of Pb loss in the thermal MOCVD process, an excess Pb concentration and a high oxygen partial pressure must be used to make stoichiometric PGO thin films and avoid the Pb and O deficiency.

The Pb precursors for MOCVD PGO film are liquids or solids that can be sublimed into a gas phase and transported into a reactor. The process window of Pb precursors is very narrow, *i.e.,* the sublimation temperature of the Pb precursors is close to the decomposition and condensation temperature, in which case the reagent may begin to decompose or condense in the reactant lines before reaching the reactor, making it very difficult to control the stoichiometry of the deposited films. The Pb precursor gas easily reacts with oxygen in the gas phase before deposition, which results in large particles and a cloudy film, especially at higher deposition temperatures.

In a traditional MOCVD process for forming oxide thin films, oxygen is mixed with thin film precursors. The mixed gases are injected into a reactor, or oxygen and the precursors are individually directed into a shower head and mixed in the shower head before deposition. these techniques allow premature gas phase reaction to occur in the reactant lines and in the shower head, which causes particulate formation, especially at high growth rates and at high deposition temperature. To insure precise deposition of oxide thin films, a high O₂ partial pressure and distribution are required. A low O₂ partial pressure results in incomplete decomposition of the precursors and incomplete oxidation of thin films, as well as contamination of carbon in the films, which causes the films to have a high leakage current. A high O₂ partial pressure allows the reaction between the precursor and oxygen to occur in the gas phase. In the case of large area substrates, a non-homogeneous distribution of oxygen causes non-uniform thin films. Therefore, traditional MOCVD processes cannot produce high quality, large area PGO thin films with a high growth rates at high deposition temperature. For these reasons, ferroelectric PGO thin films have not been made by MOCVD.

### Summary of the Invention

A method of making ferroelectric PGO thin films includes depositing Pb and Ge on a substrate using a thermal MOCVD process, wherein the Pb and Ge precursor gases are separately supplied to a region adjacent the substrate; annealing the substrate in a first annealing step; forming top electrodes on the substrate; and annealing the substrate in a second annealing step. A system for forming ferroelectric PGO thin films includes a reaction chamber, having a substrate support therein; a substrate located on said substrate support; precursor gas lines extending from a precursor gas source into said reaction chamber; background gas lines for providing a background gas into said reaction chamber; and separation means for separating the precursor gases until the precursor gases are adjacent said substrate.

An object of the invention is to provide a metalorganic chemical vapor deposition and annealing processes for lead germanium oxide (PGO) thin film materials.

Another object of the invention is to provide a system for performing metalorganic chemical vapor deposition and annealing processes for lead germanium oxide (PGO) thin film materials

These and other objects and advantages of the invention will become more fully apparent as the description which follows is read in conjunction with the drawings.

### Brief Description of the Drawings

Fig. 1 is a flow chart depicting the steps of the invention.

Fig. 2 is a somewhat schematic representation of the system of the invention.

Fig. 3 depicts a hysteresis loop of a Pt - Pb₅Ge₃O₁₁ - Ir capacitor having a C-axis orientation, constructed according to the invention..

Fig. 4 depicts the fatigue property of the capacitor of Fig. 3.

Fig. 5 depicts the hysteresis loops of the capacitor of Fig. 3.

Fig. 6 depicts the leakage current vs. applied voltage of the capacitor of Fig. 3.

Fig. 7 depicts the dielectric constant vs applied voltage the capacitor of Fig. 3.

Fig. 8 depicts a hysteresis loop of a Pt - Pb₅Ge₃O₁₁ with Pb₃GeO₅ - Ir capacitor constructed according to the invention.

Fig. 9 depicts the fatigue property of the capacitor of Fig. 8.

Fig. 10 depicts the hysteresis loops of the capacitor of Fig. 8, before and after fatigue of 1x10⁻⁹ switch cycles.

Fig. 11 depicts the retention properties of the capacitor of Fig. 8.

Fig. 12 depicts the imprint properties of the capacitor of Fig. 8.

Fig. 13 depicts the leakage current vs. applied voltage of the capacitor of Fig. 8.

Fig. 14 depicts the dielectric constant vs. applied voltage of the capacitor of Fig. 8.

### Detailed Description of the Preferred Embodiments

The system of the invention utilizes separated injection lines and gas curtain flows, or extending lines, to avoid a pre-reaction between a Pb precursor, a Ge precursor and oxygen, all in gas phases, before deposition on the surface of a subject substrate. This system uses between about 2% and about 50% excess Pb, along with a high oxygen flow, having a partial pressure of about 10% to about 60%, which is introduced into a reactor, to compensate for Pb loss in the processes and avoid any Pb and/or O deficiency. An appropriate second phase of Pb₃GeO₅ can decrease the deposition temperature and improve the ferroelectric properties of Pb₅Ge₃O₁₁ thin films.

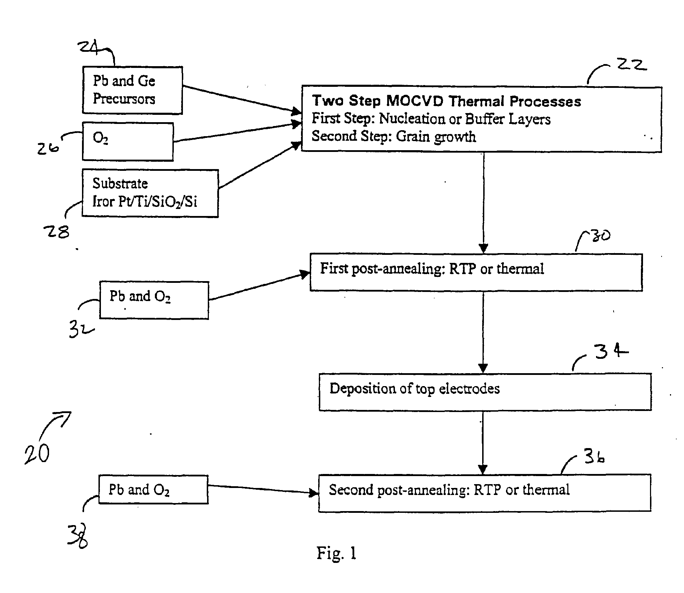

Fig. 1 is a flow chart showing the processing steps for making a metal-PGO-metal capacitor, generally at 20. Polycrystalline Pb₅Ge₃O₁₁ thin films, with preferred C-axis orientation, and Pb₅Ge₃O₁₁ with Pb₃GeO₅ thin films, with very good ferroelectric properties were deposited on 6" Ir (150nm)-Ti(25nm)-SiO₂(100nm)-Si using the MOCVD processes. A three step process is used to make high quality PGO thin films. First step 22 is a two sub-step process, and includes depositing a nucleation, or buffer, layer, and then further depositing material to promote grain growth. A thermal MOCVD deposition process, which takes place at a relatively low deposition temperature, below 700°C, is used to deposit high quality PGO films with excellent step coverage. In first step 22, Pb and Ge precursors 24 and O₂, 26, are provided in gas phase compounds, along with a suitable substrate, such as Ir or Pt on a layer of Ti, which is carried on a layer of SiO₂, which is on a Si substrate. The thermal MOCVD processes may be used to improve lattice mismatch between the film and substrates and to produce homogeneous and preferred orientation PGO thin films. The distribution of oxygen and reactant flow is controlled across the large deposition area covering one or multiple wafers.

The second step is a RTP (Rapid Thermal Process) or thermal annealing step 30, a first annealing step, which takes place in a O₂, or Pb and O₂, atmosphere 32 to achieve desired grain size and properties before top electrode deposition 34 takes place. The third step is another RTP or thermal annealing step 36, a second annealing step, which also takes place in an O₂, or Pb and O₂, atmosphere 38 to improve interface properties between the film and top electrodes. This novel process offers high quality PGO thin films over large area substrates with high growth rates

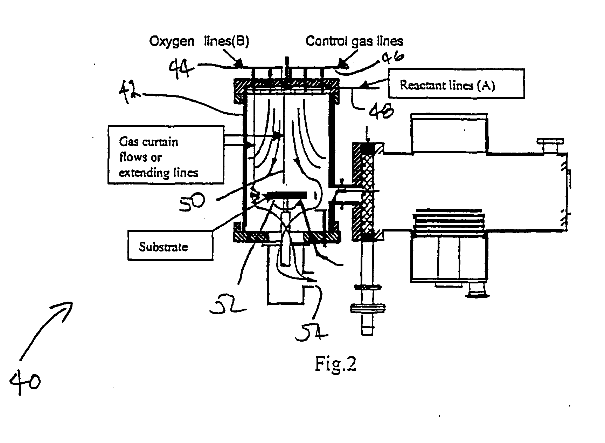

Referring now to Fig. 2, a system constructed according to the invention is depicted generally at 40. System 40 utilizes separated inject lines and gas curtain flows, or extended reactant lines, to avoid early reaction between the Pb and Ge precursors and oxygen before deposition on the surface of the substrate. System 40 includes a reaction chamber 42, which is fed by oxygen lines 44, control, or background, gas lines 46, and reactant lines 48. The background gas lines 4b feed a gas curtain flow 50, in the preferred embodiment. A substrate 52 is supported on a suitable mount. Gas outflow 54 is provided.

The Pb and Ge precursor gases are injected into the reactor from lines 48, and three mass flow controllers (MFC) are used to control the distribution of the precursor gases. The oxygen is injected into the reactor from line 44, and three MFCs, or needle valves, are used to control the distribution of the oxygen. As the process takes place in an oxygen atmosphere, oxygen is the background gas, and may be provided as pure O₂, N₂O, or a mixture of O₂ and N₂O. In the preferred embodiment, an Ar curtain flow is used to separate the oxygen and precursor gases. Alternately, lines 44, 48 may be extended to introduce oxygen close to the surface of the substrate. The gas curtain flow and the extended precursor gas lines are referred to herein as precursor gas separation means. Lines 44, 46, and 48, as well as the walls of reaction chamber 42 and outflow 54 are provided with a heating system, which, in the preferred embodiment, takes the form of a controlled heating system, for maintaining the precursor gases, curtain gases and background gases at a temperature to insure that the gases remain in an appropriate gas phase. The lines and reaction chamber wall may be wrapped in a heat tape, or enveloped in a silicon oil heating mechanism to maintain an appropriate temperature. The heating system includes, in the preferred embodiment, thermocouple heat sensors to provide input for the control mechanism.

The precursors for PGO thin films are listed in Table 1.

**Table 1**

| **Properties of precursors for PGO thin films** | | | |
|---|---|---|---|
| Precursors | Formula | Vapor Pressure (mm Hg) | Decomposition Temperature(°C) |
| Pb(TMHD)₂ | Pb(C₁₁H₁₉O₂)₂ | 180°C/0.05 | 325°C |
| Ge(ETO)₄ | Ge(C₂H₅O)₄ | b.p. 185.5°C | |

Pb(thd)₂ and Ge(ETO)₄, having a molar ratio of 5:3 with Pb having an excess of from about 1% to about 30% over the stoichiometric requirement are dissolved in a mixed solvent of tetrahydrofuran, isopropanol and tetraglyme, in the molar ratio of 8:2:1. The precursor solutions have a concentration of 0.1 - 0.3 M/L of PGO. The solution is injected into a vaporizer at between about 180°C to about 250°C, by a pump at a rate of 0.1 - 0.5 ml/min to form the precursor gases. The precursor gases are introduced into reaction chamber 42 using a preheated argon flow at about 180° C to about 250°C. The deposition temperatures and pressure are about 400°C to about 650°C and 2 - 20 torr, respectively. The shroud flow is introduced into reaction chamber 42 with an Ar flow of about 2000 sccm to about 6000 sccm, with an oxygen flow of about 500 sccm to about 3000 sccm.

For MOCVD first step 22, a two sub-step MOCVD process may be used to improve lattice mismatch between the film and the substrates and get homogeneous and preferred orientation PGO thin films. In the first sub-step MOCVD process a very thin nucleation layer of the desired materials, or a buffer layer, is deposited at a relatively low temperature of about 400°C to about 500°C. In the second sub-step, the deposition temperatures increased to about 500°C to about 700°C, to promote grain growth. After deposition, the PGO films are cooled to room temperature in am oxygen atmosphere.

In second step 30, the PGO thin films are transferred to RTP, or thermal oven, for annealing in O₂, or Pb and O₂, atmosphere, with an appropriate Pb and O₂ partial pressure and temperature of about 500°C to about 750°C, to achieve desired grain size and properties.

In third step 36, the PGO thin films are transferred to RTP or thermal oven again for annealing in O₂, or Pb and O₂, atmosphere with an appropriate Pb and O₂ partial pressure at temperatures from about 500°C to about 750°C, to improve interface properties between the film and top electrodes.

The basic composition, phase, and ferroelectric and electrical properties of the polycrystalline Pb₅Ge₃O₁₁ thin films with preferred C-axis orientation and polycrystalline Pb₅Ce₃O₁₁ thin films with second phase Pb₃GeO₅ were measured. The compositions of the PGO thin films were analyzed by using energy dispersion X-ray analysis (EDX). The phases of the films were identified using x-ray diffraction. The thickness and surface morphologies of the films on Ir/Ti/SiO₂/Si substrates were investigated by scanning electronic microscope. The leakage currents and dielectric constants of the films were measured using HP 4155-6 precision semiconductor parameter analyzer and Keithley 182 CV analyzer respectively. The ferroelectric properties of the films were measured by a standardized RT66A tester. Analysis results for the two kinds of PGO thin films made by the MOCVD and annealing processes are now presented.

### The Polycrystalline Pb₅Ge₃O₁₁ thin films with C-axis orientation

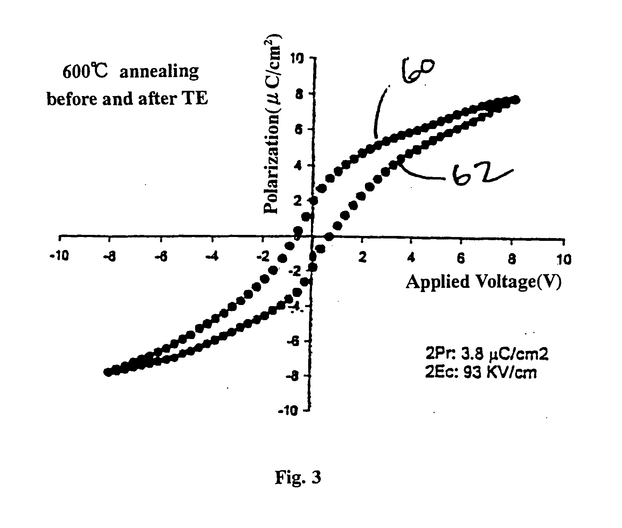

The measurements of the composition and X-ray pattern confirmed that the Pb₅Ge₃O₁₁ thin films having a C-axis orientation were deposited on substrate 52. The Pb₅Ge₃O₁₁ thin films demonstrated good ferroelectric properties with 2Pr 3.8 µC/cm², and resulted in the hysteresis loop, as shown in Fig. 3, before annealing at 60, and after TE at 62.

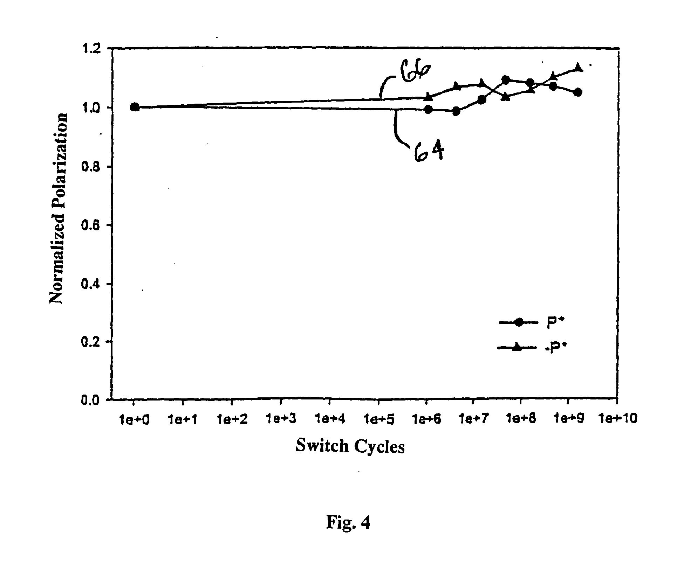

The fatigue properties of the Pb₅Ge₃O₁₁ thin film shown in Fig. 4 at 64, 66 were measured at switch cycles 1x10⁹. The Pb₅Ge₃O₁₁ thin films on Ir substrate are nearly fatigue free, as shown by hysteresis loop 64 of the Pb₅Ge₃O₁₁ films before fatigue, and the hysteresis loop 66 after fatigue.

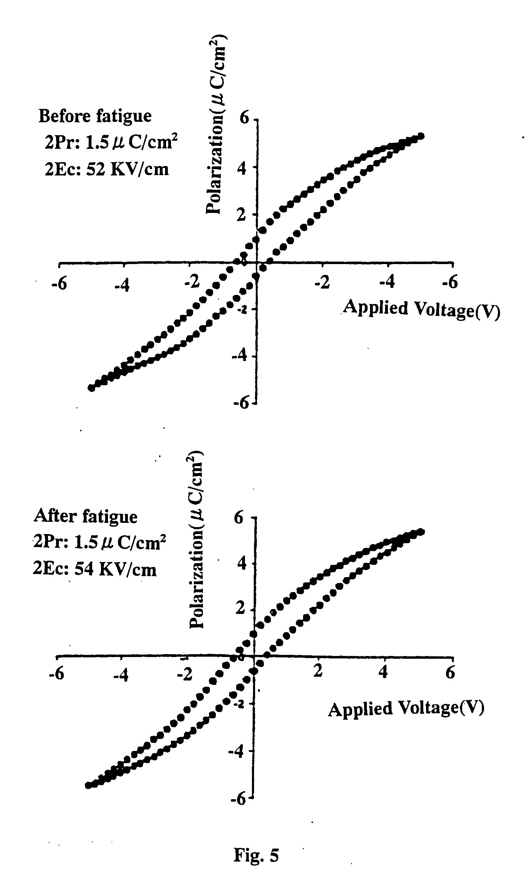

The remanent polarization (2Pr) and coercive field (2Ec) of the films were 1.5 µC/cm² and 52 KV/cm before fatigue, shown in Fig. 5a, and 1.5 µC/cm² and 54 KV/cm after fatigue, as shown in Fig.5b.

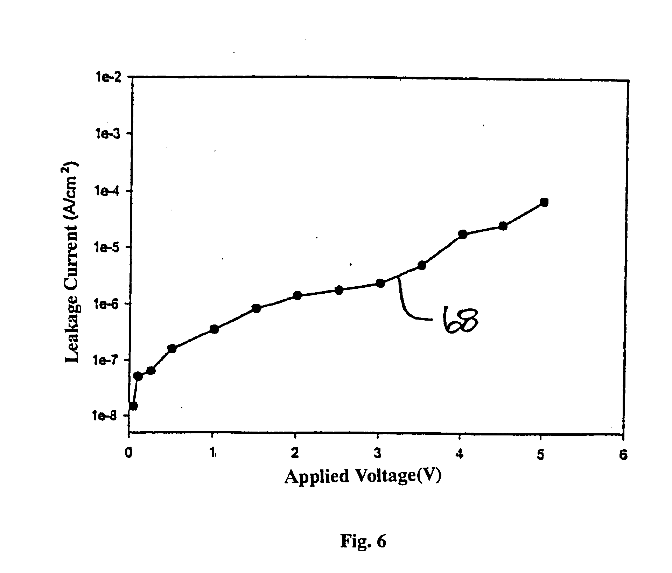

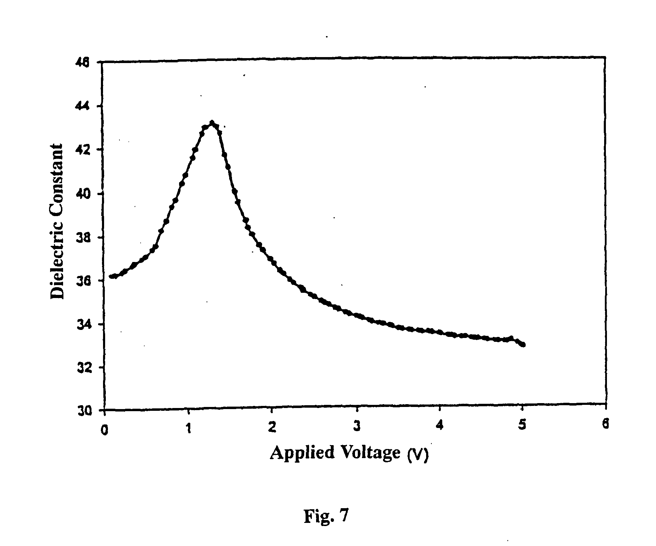

The leakage current of the PGO films is depicted in Fig. 6 at 68.The leakage current increased with increasing applied voltage, and was found about 3.6x10⁻⁷ A/cm² at 100KV/cm. The dielectric constant of the PGO thin films showed the similar behavior to the most ferroelectric materials, which dielectric constant changed with applied voltage. The maximum dielectric constant of the PGO film was close to 45, as shown in Fig. 7.

### The polycrystalline Pb₅Ge₃O₁₁ with Pb₃GeO₅ thin films

The experimental results demonstrated that the composition of the PGO thin film with good ferroelectric properties is Pb₅Ge₃O₁₁ having an appropriate excess Pb layer, which is located between Pb₅Ge₃O₁₁ and Pb₃GeO₅ in PbO - GeO₂ phase diagram. In theory, a single phase Pb₅Ge₃O₁₁ with C-axis orientation has the best ferroelectric properties. Because of Pb loss during fabrication, excess Pb, or the second phase of Pb₃GeO₅, is necessary to make up for the Pb loss and avoid a Pb and/or O deficiency. The Pb excess improves the ferroelectric properties of MOCVD PGO thin films. The experimental results confirmed that the polycrystalline Pb₅Ge₃O₁₁ with Pb₃GeO₅ thin films, formed at a lower deposition temperature, had very good ferroelectric properties.

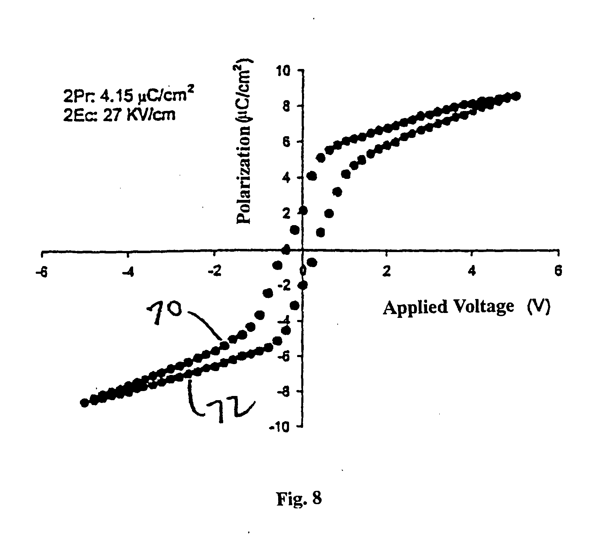

Fig. 8 depicts the hysteresis loop of the PGO thin films on Ir substrate before annealing at 70, and after TE at 72. The hysteresis loop with 2Pr: 4.15 µC/cm² and 217 KV/cm was square, symmetric and saturated. The fatigue properties of the PGO thin film were measured at switch cycles 1x10⁶, 1x10⁹ and 1x10¹⁰.

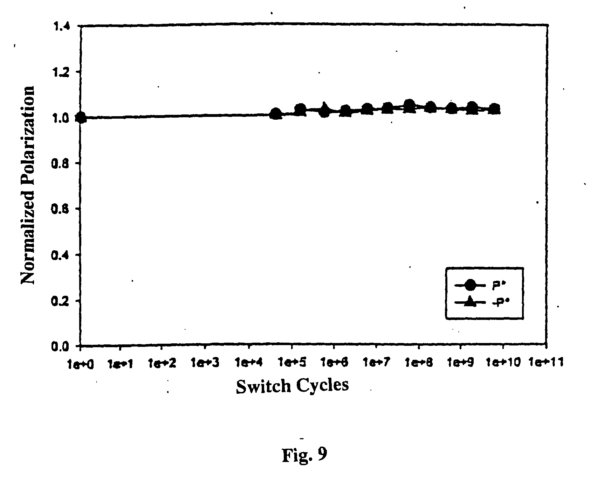

Fig. 9 depicts experimental results of fatigues testing. The PGO thin films on Ir substrate are virtually fatigue free, as indicated by the before and after traces, which are substantially overlaid on one another. The hysteresis loops of the PGO films before and after fatigue had no change.

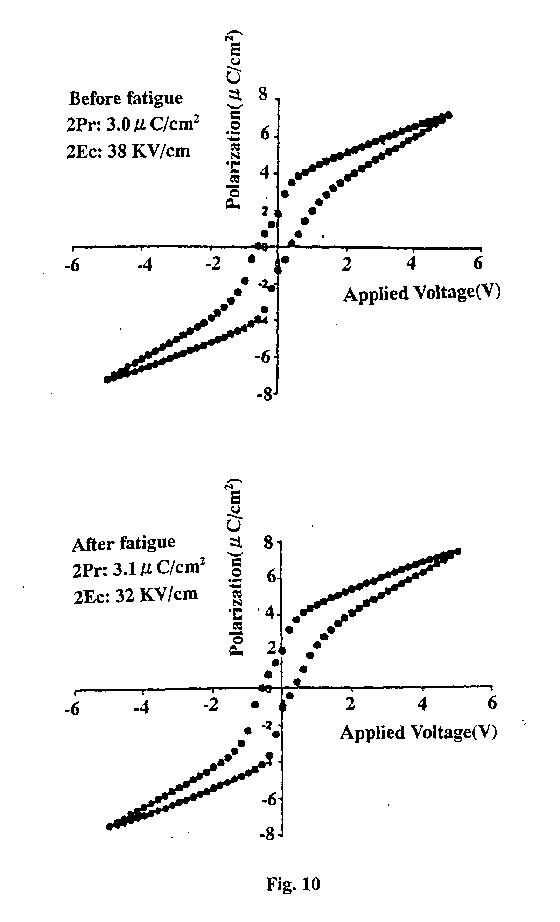

The remanent polarization (2Pr) and coercive field (2Ec) of the films were 3.0 µC/cm² and 38 KV/cm before fatigue, and 3.1 µC/cm² and 32 KV/cm after fatigue respectively, as shown in Fig. 10.

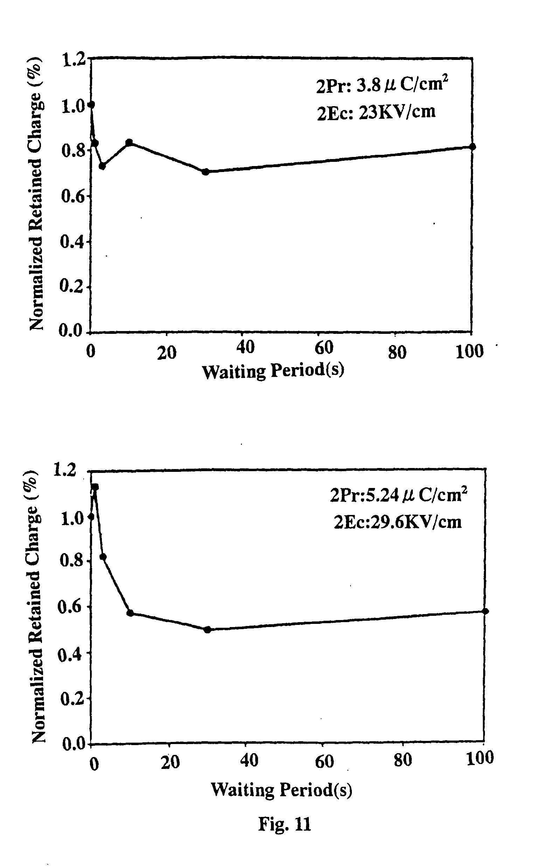

The retention properties of the PGO thin films are depicted in Fig. 11. The retained charge of the PGO thin films dropped nearly 50% at most when the waiting time increased to 10 seconds, after that, the retained charge was stable with increasing waiting time. The retention properties of PGO thin films were similar with that of Pb(Zr, Ti)O₃ (PZT) thin films.

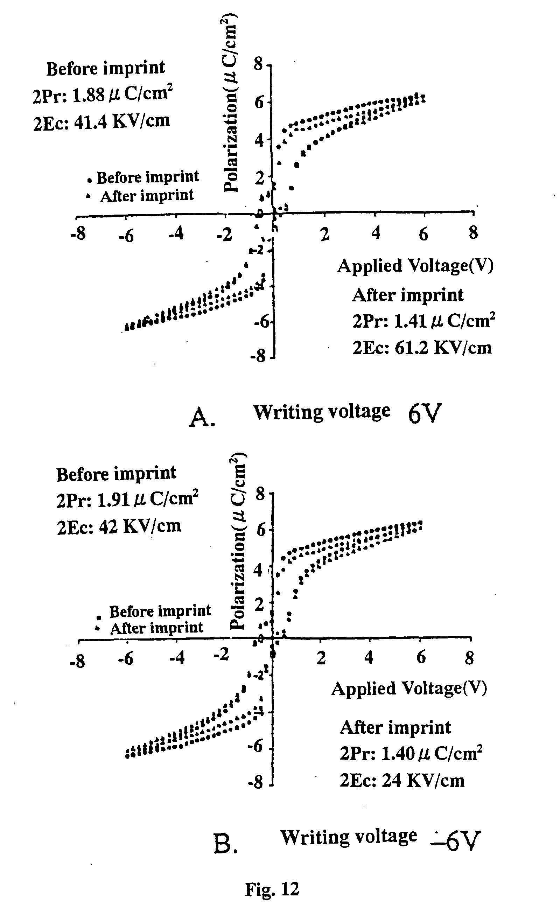

The imprint properties of the PGO thin film were also measured and are depicted in Fig. 12) It was found that the remanent polarization of the PGO film decreased from 1.88 µC/cm² to 1.41 µC/cm², and from 1.91 µC/cm² to 1.40 µC/cm² at writing voltage 6V and -6V, respectively, after an imprint at 100°C for 100 minutes. The results showed very small imprint properties of the PGO thin films.

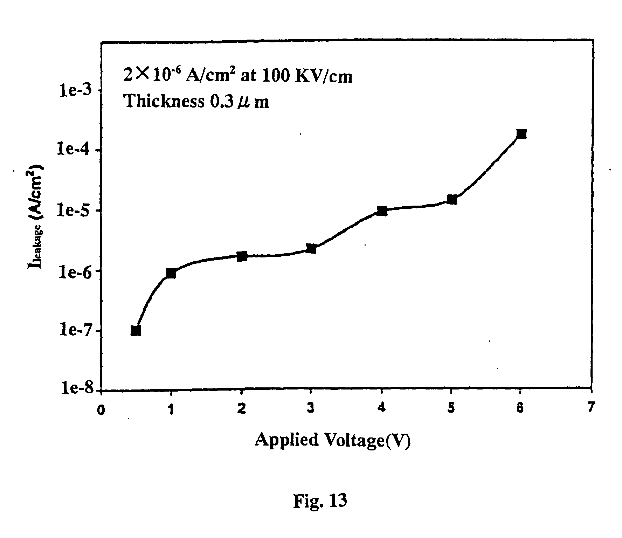

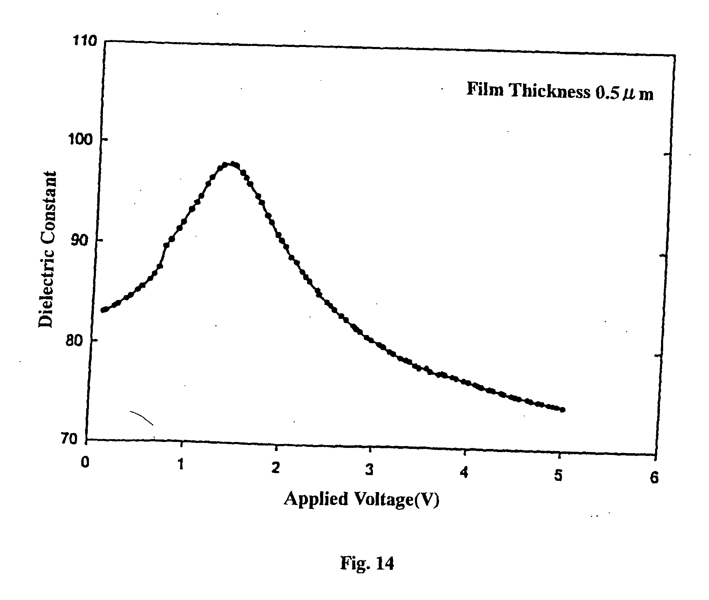

The leakage current of the PGO films increased with increasing applied voltage, and was found about 2x10⁻⁶ A/cm² at 100KV/cm, as shown in Fig. 13. The dielectric constant of the PGO thin films showed the similar behavior to the most ferroelectric materials, which dielectric constant changed with applied voltage. The maximum dielectric constant, shown in Fig. 14, of the PGO film was close to 100.

Thus a system and method have been disclosed for depositing PGO thin films. Although a preferred embodiment of the invention and several variations thereof have been disclosed, it will be appreciated that further modifications and variations may be made thereto without departing from the scope of the invention as defined in the appended claims.

## Claims

1. A method of making ferroelectric PGO thin films, comprising:
depositing Pb and Ge on a substrate using a thermal MOCVD process, wherein the Pb and Ge precursor gases are separately supplied to a region adjacent the substrate;
annealing the substrate in a first annealing step;
forming top electrodes on the substrate; and
annealing the substrate in a second annealing step.

2. The method of claim 1 wherein said depositing includes depositing a nucleation layer at a first temperature and then depositing additional material at a second temperature, wherein the second temperature is higher than the first temperature.

3. The method of claim 2 wherein said depositing includes depositing a nucleation layer of the materials taken from the group of material consisting of GeO₂ and PbO, and wherein the first temperature is a range of from about 400°C to about 500°C and at a pressure within a range of about 1 torr to about 10 torr; and wherein said depositing further includes setting the second temperature ion a range from about 500°C to about 700°C and at a pressure with a range of about 1 torr to about 20 torr.

4. The method of claim 3 wherein said depositing includes forming the nucleation layer over the entire surface of the substrate at a thickness of about 5 nm to about 50 nm.

5. The method of claim 2 wherein said depositing includes depositing the nucleation layers at an oxygen partial pressure with a range of from about 5% to about 40%.

6. The method of claim 1 which includes separating the precursor gases from one another with a gas curtain flow.

7. The method of claim 1 which includes separating the precursor gases from one another by providing separate feed lines, which feed lines terminate adjacent the substrate.

8. The method of claim 1 which includes providing from about 2% to about 50% excess Pb above the stoichiometric requirement and providing an oxygen flow having a partial pressure of about 10% to about 60%.

9. The method of claim I which includes providing a second phase of Pb₃GeO₅ in a range of about 1% to about 20% at a decreased deposition temperature.

10. The method of claim 1 wherein said first annealing includes placing the deposited PGO thin films in an RTP or thermal oven for annealing in O₂ or Pb and O₂ atmosphere with an appropriate Pb and O₂ partial pressure at temperature of about 500°C to about 750°C to achieve desired grain size and properties; and wherein said second annealing includes placing the structure in an RTP or thermal oven again for annealing in O₂ or Pb and O₂ atmosphere with an appropriate Pb and O₂ partial pressure at temperature of about 500°C to about 750°C to improve interface properties between the film and top electrodes.

11. The method of claim 1 wherein said depositing including depositing in an oxygen atmosphere, which is comprised of pure O₂, N₂O, or a mixture of O₂ and N₂O.

12. A system for forming ferroelectric PGO thin films, comprising:
a reaction chamber, having a substrate support therein;
a substrate located on said substrate support;
precursor gas lines extending from a precursor gas source into said reaction chamber;
background gas lines for providing a background gas into said reaction chamber; and
separation means for separating the precursor gases until the precursor gases are adjacent said substrate.

13. The system of claim 12 wherein said precursor gas lines and said background gas lines include a controlled heating systems for maintaining the precursor gases and background gases in a gas phase.

14. The system of claim 13 wherein said heating system includes a heating mechanism taken from the group of heating mechanisms consisting of heat tapes and silicon oil heating mechanisms; and wherein said heating system includes thermocouples temperature sensors.

15. The system of claim 12 wherein said separation means includes a gas curtain flow for separating the precursor gases within said reaction chamber.

16. The system of claim 12 wherein said separation means includes extending said precursor gas lines into said reaction chamber and terminating said precursor gas lines adjacent said substrate support.
